**Europäisches Patentamt**

**European Patent Office**

**Office européen des brevets**

(19)

(11) Veröffentlichungsnummer: **0 224 707 B1**

# EUROPÄISCHE PATENTSCHRIFT

(12)

(45) Veröffentlichungstag der Patentschrift:
16.01.91 Patentblatt 91/03

(51) Int. Cl.$^5$: **G01R 19/165**

(21) Anmeldenummer: **86114814.6**

(22) Anmeldetag: **24.10.86**

(54) Schaltungsanordnung zum selbsttätigen Überwachen mehrerer analoger elektrischer Signale.

(30) Priorität: **22.11.85 DE 3541343**

(43) Veröffentlichungstag der Anmeldung:
**10.06.87 Patentblatt 87/24**

(45) Bekanntmachung des Hinweises auf die
Patenterteilung:
**16.01.91 Patentblatt 91/03**

(84) Benannte Vertragsstaaten:
**CH DE FR GB IT LI NL SE**

(56) Entgegenhaltungen:
**DE-A- 3 002 199
DE-B- 1 284 987
DE-B- 1 944 191
ELECTRONIC DESIGN, Band 32, Nr. 25,
Dezember 1984, Seite 269, Waseca, MN, US; C.
PANASUK: "CMOS comparator chip
multiplexes 4 inputs under digital control"**

(73) Patentinhaber: **Siemens Nixdorf
Informationssysteme Aktiengesellschaft
Fürstenallee 7
D-4790 Paderborn (DE)**

(72) Erfinder: **Esser, Wolfgang
Erikaweg 2
D-4790 Paderborn (DE)**
Erfinder: **Jung, Peter
Bleichstrasse 20
D-4790 Paderborn (DE)**

(74) Vertreter: **Schaumburg, Thoenes &
Englaender
Mauerkircherstrasse 31 Postfach 86 07 48
D-8000 München 86 (DE)**

**Beschreibung**

Die Erfindung betrifft eine Schaltungsanordnung zum selbsttätigen Überwachen mehrerer analoger elektrischer Signale auf Einhaltung vorgegebener Toleranzbereiche durch sukzessives Vergleichen mit Referenzwerten und vergleichsabhängiges Erzeugen und Speichern von Fehlersignalen. Eine Schaltungsanordnung dieser Art ist aus der US-Patentschrift 4 454 500 (=DE-A-3002199) bekannt.

Es ist bei der Überwachung elektrischer Anlagen, beispielsweise in Fernmelde- oder Datenverarbeitungsanlagen, häufig erforderlich, mehrere analoge elektrische Signale hinsichtlich der Einhaltung vorgegebener Toleranzbereiche zu überwachen. Die vorstehend genannte bekannte Schaltungsanordnung könnte zwar zu diesem Zweck eingesetzt werden, jedoch müßten hierzu relativ umständliche Funktionsschritte programmiert werden, die sich durch einen komplizierten Schaltungsaufbau ergeben. Im Laufe des sukzessiven Vergleichs eines analogen elektrischen Signals mit den Referenzwerten ist für jeden Vergleichsvorgang das Laden eines Referenzwertes in ein Datenregister und das Abfragen eines Sperregisters erforderlich das einem Vergleicher nachgeschaltet ist. Erst nach diesen Schritten können die Abfrageergebnisse der Sperregister in einem Mikroprozessor ausgewertet werden. In der zwischen den Abfragen der Sperregister liegenden relativ langen Zeit können fehlerhafte Überwachungsergebnisse entstehen, wenn sich das analoge Signal ändert bzw. der auswertende Mikroprozessor durch andere Programme unterbrochen wird.

Insbesondere für den vorstehend genannten Einsatzzweck sollte es möglich sein, die Überwachung mehrerer analoger Signale selbsttätig in einem zyklischen Ablauf durchzuführen und die Überwachungsergebnisse nach einem jeweiligen Zyklus verfügbar zu haben. Auch dies ist mit der bekannten Schaltungsanordnung nicht ohne weiteres möglich.

Es ist Aufgabe der Erfindung, eine Schaltungsanordnung anzugeben, die diese Anforderungen erfüllt und Überwachungsfehler der bekannten Schaltungsanordnung vermeidet.

Diese Aufgabe wird für eine Schaltungsanordnung eingangs genannter Art erfindungsgemäß dadurch gelöst, daß taktgesteuert gleichzeitig mit der Anschaltung des jeweiligen zu überwachenden Signals an einen Komparator ein Zugriff auf einen Referenzwertespeicher erfolgt, aus dem einem jeden Signal zugeordnete und einen Toleranzbereich definierende Referenzwerte nacheinander taktgesteuert ausgelesen und dem Komparator zugeführt werden und daß das jeweilige Ausgangssignal des Komparators zur Erzeugung gleichartiger zu speichernder Fehlersignale mit einem Auswertesignal logisch verknüpft wird, das angibt, welcher der beiden Referenzwerte jeweils am Komparator anliegt.

Die Erfindung sieht also vor, daß in bestimmter zeitlicher Zuordnung zueinander taktgesteuert die sukzessive Anschaltung des jeweiligen zu überwachenden Signals mit der Anschaltung zuvor gespeicherter Referenzwerte koordiniert wird und daß gleichartige, in bestimmter logischer Verknüpfung erzeugte Fehlersignale gespeichert werden. Dies macht insgesamt ein zyklisches selbsttätiges Abfragen mehrerer Überwachungspunkte in einem elektrischen Gerät möglich, wobei die Überwachungsergebnisse nach einem jeweiligen Zyklus gewissermaßen als ein Bündel von Aussagen einem Speicher entnommen werden können. Durch Verwendung eines Referenzwertespeichers ist es möglich, jedem derartigen Überwachungszyklus neue Referenzwerte für jedes Analogsignal zugrunde zu legen.

Das digitale Ausgangssignal eines Komparators hat bei der Überschreitung eines Referenzwertes durch ein Eingangssignal beispielsweise den Zustand L. Bei der Unterschreitung eines Referenzwertes hat es dann den Zustand H. Eine Überschreitung des größeren Referenzwertes und eine Unterschreitung des kleineren Referenzwertes kann bei Verwendung eines einzigen Komparators beim jeweiligen Vergleich nur an einem bestimmten Fehlersignalzustand, also entweder nur am Zustand L oder nur am Zustand H erkennbar sein. Deshalb sieht die Erfindung die Erzeugung eines Fehlersignals mit einem bestimmten Zustand vor, indem das Ausgangssignal des Komparators mit einem den jeweils wirksamen Referenzwert identifizierenden Auswertesignal logisch verknüpft wird, so daß ein Überschreiten oder ein Unterschreiten eines Referenzwertes gleichartig, d.h. als Abweichen von dem vorgegebenen Toleranzbereich signalisiert wird.

In einer bevorzugten Weiterbildung der Erfindung ist zur sukzessiven Zuführung der analogen elektrischen Signale zum Komparator ein Multiplexer vorgesehen. Mit diesem können die die zu überwachenden Signale führenden Leitungen durch eine entsprechende Multiplexeradressierung in einfacher Weise nacheinander mit dem Komparator verbunden werden.

In einer Weiterbildung der Erfindung ist der Komparator zur Ansteuerung mit den Referenzwerten über einen Digital/Analog-Umsetzer mit dem die Referenzwerte digital enthaltenden Referenzwertespeicher verbunden. Durch die Speicherung der Referenzwerte in digitaler Form und Zuführung derselben zum Komparator über einen Digital/Analog-Umsetzer ist ein hoher Genauigkeitsgrad der Referenzwerte am Komparator gewährleistet.

Wenn der Referenzwertespeicher gemäß einer Weiterbildung der Erfindung frei programmierbar ist, so können die im Referenzwertespeicher digital enthaltenen Referenzwerte beliebig geändert werden.

In einer weiteren Ausbildung der Erfindung enthält der Referenzwertespeicher für jedes zu überwachende Signal unter einer geradzahligen Adresse den kleinen oder den großen Referenzwert und unter der nächsthöheren, ungeradzahligen Adresse den großen bzw. den kleinen Referenzwert und wird der Referenzwertespeicher mit gegenüber dem Multiplexer doppelter Frequenz bei sukzessiv ansteigender Adressenfolge adressiert. Es ist dadurch in einfacher Weise gewährleistet, daß dem Komparator mit jedem zu überwachenden Signal die Referenzwerte nacheinander zugeführt werden.

Dies wird bei einer Schaltungsanordnung zur Überwachung von maximal $2^N$ analogen elektrischen Signalen gemäß einer Weiterbildung der Erfindung in einfacher Weise dadurch realisiert, daß der Referenzwertespeicher mit den Signalen der Zählerbits 0 bis N und der Multiplexer mit den Signalen der Zählerbits 1 bis N eines Binärzählers adressiert wird. Da dem Multiplexer das niedrigstwertige Zählerbit 0 des Binärzählers nicht zugeführt wird, wird die Adresse des Multiplexers nur bei jedem zweiten Zählschritt des Binärzählers um 1 erhöht. Da aber die Adresse des Referenzwertespeichers bei jedem Zählschritt des Binärzählers um 1 erhöht wird, werden unter jeder Adresse des Multiplexers d.h. bei jedem dem Komparator zugeführten Signal zwei Speicherzellen des Referenzwertespeichers ausgelesen, deren Inhalte über den Digital/Analog-Umsetzer dem Komparator zugeführt werden. Wenn nun jeweils die eine Speicherzelle einen kleinen Referenzwert und die andere Speicherzelle einen großen Referenzwert enthält, so wird jedes zu überwachende analoge elektrische Signal im Komparator mit zwei einen vorgegebenen Toleranzbereich begrenzenden Referenzwerten verglichen.

Bei Anwendung dieser Art der Adressierung des Multiplexers und des Referenzwertespeichers wird das Auswertesignal, das angibt, welcher der beiden Referenzwerte jeweils am Komparator anliegt, vorteilhaft durch das Zählerbit 0 des Binärzählers gebildet. Enthält der Referenzwertespeicher beispielsweise für jedes zu überwachende Signal unter einer geradzahligen Adresse den kleinen Referenzwert und unter der nächsthöheren, ungeradzahligen Adresse den großen Referenzwert, so befindet sich das Zählerbit 0 des Binärzählers im Zustand L, wenn gerade ein kleiner Referenzwert aus dem Referenzwertespeicher ausgelesen wird, und im Zustand H, wenn gerade ein großer Referenzwert aus dem Referenzwertespeicher ausgelesen wird.

In einer vorteilhaften Weiterbildung der Erfindung erfolgt die logische Verknüpfung des jeweiligen Ausgangssignals des Komparators mit dem Signal des Zählerbits 0 des Binärzählers durch ein EXKLUSIV-ODER-Glied. Ist wiederum in dem Referenzwertespeicher für jedes zu überwachende Signal unter einer geradzahligen Adresse der kleine Referenzwert und unter der nächsthöheren, ungeradzahligen Adresse der große Referenzwert gespeichert, und nimmt das Ausgangssignal des Komparators den Zustand L an, wenn ein überwachtes Signal größer als ein Referenzwert ist, und den Zustand H an, wenn ein überwachtes Signal kleiner als ein Referenzwert ist, so erhält man durch die EXKLUSIV-ODER-Verknüpfung des jeweiligen Komparatorausgangssignals mit dem Signal des Zählerbits 0 des Binärzählers, der den Referenzwertespeicher adressiert, ein einheitliches Fehlersignal, das beim Zustand H entweder eine Unterschreitung des kleinen Referenzwertes oder eine Überschreitung des großen Referenzwertes, also ein Abweichen vom vorgegebenen Toleranzbereich signalisiert.

In einer weiteren Ausbildung der Erfindung sind der Multiplexer und der Komparator über ein hinsichtlich der Übernahme des jeweiligen Multiplexerausgangssignals steuerbares Halteglied miteinander verbunden, dessen Steuereingang an den Ausgang eines UND-Gliedes angeschlossen ist, das das invertierte Signal des Zählerbits 0 des Binärzählers mit einem diesen inkrementierenden Taktsignal verknüpft. Das Halteglied dient dabei zur definierten Übernahme und Zwischenspeicherung des jeweiligen Multiplexerausgangssignals.

In einer bevorzugten Weiterbildung der Erfindung werden die in einem Überwachungszyklus auftretenden Fehlersignale jeweils bis zum Beginn des nächsten Überwachungszyklus in einem Schieberegister gespeichert. Daraus ergibt sich der Vorteil, daß der Schieberegisterinhalt am Ende eines Überwachungszyklus ausgewertet werden kann. Es kann dadurch festgestellt werden, bei welchem analogen elektrischen Signal eine Grenzwertüberschreitung bzw. Grenzwertunterschreitung aufgetreten ist.

Um diese Auswertung durch eine elektronische Datenverarbeitungsanlage selbsttätig vornehmen lassen zu können, ist in einer weiteren vorteilhaften Ausbildung der Erfindung eine Steuereinheit vorgesehen, die ferner die Programmierung des Referenzwertespeichers zwischen zwei Überwachungszyklen und das definierte Starten und Stoppen der Überwachungszyklen steuert.

Die Erfindung wird im folgenden an Hand der Figuren näher erläutert. Es zeigen :

Fig. 1 ein Ausführungsbeispiel der Erfindung und

Fig. 2 den Signalverlauf an einigen Stellen der Schaltungsanordnung von Fig. 1.

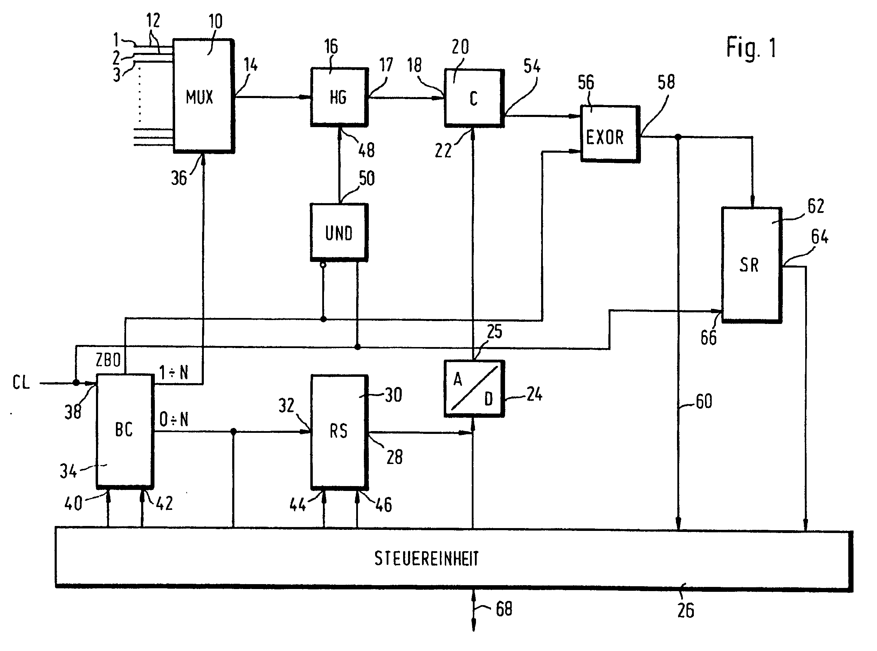

Fig. 1 zeigt eine Schaltungsanordnung zur intermittierenden selbsttätigen Überwachung mehrerer analoger elektrischer Signale hinsichtlich der Einhaltung vorgegebener Toleranzbereiche. Sie enthält einen Multiplexer 10, an dessen Eingängen 12 die zu überwachenden analogen elektrischen Signale anliegen. Der Ausgang 14 des Multiplexers 10 ist über ein hinsichtlich der Übernahme des jeweiligen Multiplexerausgangssignals steuerbares Halteglied 16 mit dem Meßeingang 18 eines Komparators 20 verbunden. Der Referenzeingang 22 des Komparators 20 ist an den Analogausgang 25 eines Digital/Analog-Umsetzers 24 angeschlossen, dessen Digitaleingang mit einer Steuereinheit 26 einerseits und mit dem Datenausgang 28 eines als Referenzwertespeicher dienenden Schreib-/Lesespeichers 30 andererseits verbunden ist. Die Adresseingänge 32 dieses Referenzwertespeichers 30 sind zum Zwecke des Einspeicherns der Referenzwerte an die Steuereinheit 26 angeschlossen. Ferner sind sie mit sämtlichen Zählerbits 0 bis N eines Binärzählers 34 verbunden, dessen Zählerbits 1 bis N auch an die Adresseingänge 36 des Multiplexers 10 angeschlossen sind.

Der Binärzähler 34 wird über seinen Takteingang 38 von einem Taktsignal CL angesteuert. Sein Zählrichtungseingang 40 und sein Zählvoreinstellungseingang 42 sind ferner mit der Steuereinheit 26 verbunden.

Auch der Referenzwertespeicher 30 ist zur Einspeicherung der Referenzwerte mit seinem Dateneingang 44 und mit seinem Schreibeingang 46 an die Steuereinheit 26 angeschlossen.

Das Halteglied 16 ist an seinem Steuereingang 48 mit dem Ausgang 50 eines UND-Gliedes 52 mit invertierendem Eingang verbunden, das das invertierte Signal ZB 0 des Zählerbits 0 des Binärzählers 34 mit dem Taktsignal CL verknüpft. Durch diese logische Verknüpfung wird bewirkt, daß das jeweilige Multiplexerausgangssignal nur bei einem geradzahligen Zählerstand des Binärzählers 34, d.h. wenn die Adresse des Multiplexers 10 gerade um 1 hochgezählt wurde, in das Halteglied 16 übernommen und von seinem Ausgang 17 an den Meßeingang 18 des Komparators 20 gelegt wird.

Der Ausgang 54 des Komparators 20 ist mit einem Eingang eines EXKLUSIV-ODER-Gliedes 56 verbunden, das das Ausgangssignal des Komparators 20 mit dem Signal ZB 0 des Zählerbits 0 des Binärzählers 34 verknüpft. Am Ausgang 58 dieses EXKLUSIV-ODER-Gliedes 56 erscheinen dann etwaige Fehlersignale, die eine Referenzwertüberschreitung und eine Referenzwertunterschreitung durch ein zu überwachendes Signal gleichartig anzeigen.

Die in einem Überwachungszyklus auftretenden Fehlersignale werden einerseits über eine Verbindungsleitung 60 der Steuereinheit 26 direkt zugeführt und andererseits bis zum Beginn des nächsten Überwachungszyklus in einem Schieberegister 62 zwischengespeichert und dann erst über dessen Ausgang 64 der Steuereinheit 26 zugeführt. Das Schieberegister 62 wird, ebenso wie der Binärzähler 34, über seinen Takteingang 66 vom Taktsignal CL gesteuert.

Die Steuereinheit 26 ist zum Zwecke der Binärzählervoreinstellung, des Einspeicherns der Referenzwerte in den Referenzwertespeicher 30 und der Auswertung der im Schieberegister 62 zwischengespeicherten Fehlersignale über ihren Anschluß 68 mit einer in der Figur nicht dargestellten elektronischen Datenverarbeitungsanlage verbunden.

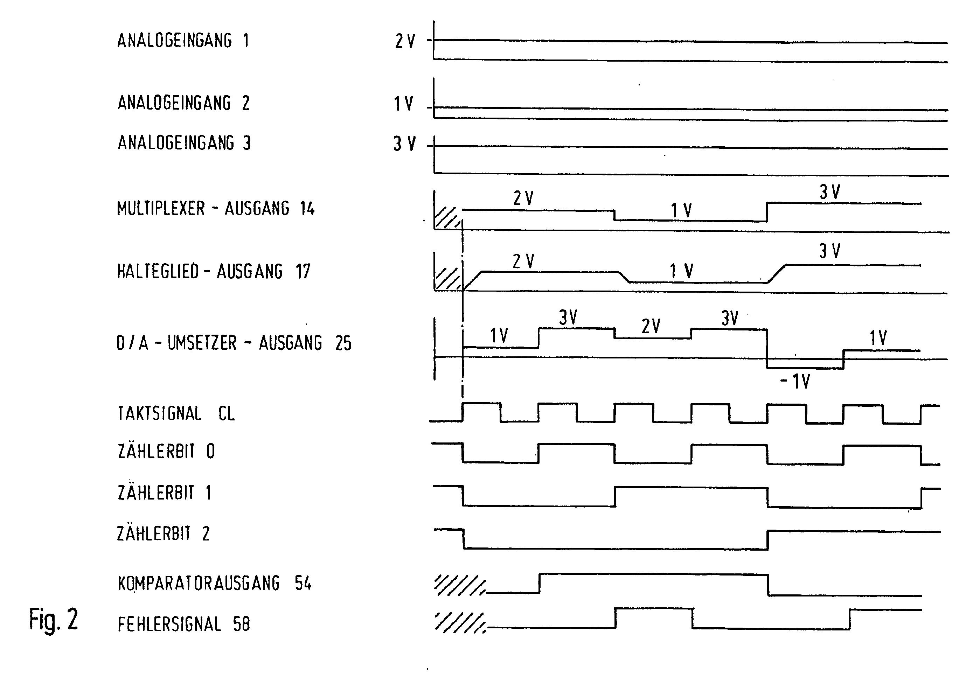

Nachdem vorstehend der Aufbau der in Fig. 1 dargestellten Schaltungsanordnung zur intermittierenden selbsttätigen Überwachung mehrerer analoger elektrischer Signale beschrieben wurde, wird im folgenden die Funktion dieser Schaltungsanordnung an Hand von Fig. 1 in Verbindung mit Fig. 2 näher erläutert.

Die zu überwachenden analogen elektrischen Signale werden den beispielsweise $2^N$ Eingängen 12 des Multiplexers 10 zugeführt. Wie bereits vorstehend erwähnt, werden die Adresseingänge 36 des Multiplexers 10 von den Zählerbits 1 bis N des Binärzählers 34 angesteuert. Im Unterschied dazu wird der Referenzwertespeicher 30 mit den Zählerbits 0 bis N des Binärzählers 34 adressiert. Der Referenzwertespeicher 30 enthält für jedes zu überwachende Signal unter einer geradzahligen Adresse (einschließlich der Adresse 0) den kleinen Referenzwert und unter der nächsthöheren, ungeradzahligen Adresse den großen Referenzwert. Diese Referenzwerte wurden während einer Initialisierungsphase unter Steuerung durch die Steuereinheit 26 durch eine in der Fig. 1 nicht dargestellte elektronische Datenverarbeitungsanlage eingespeichert. Bevor der erste Überwachungszyklus beginnen kann, wird der Binärzähler 34 auf den Zählerstand $2^{N+1}-1$ ebenfalls unter Steuerung durch die Steuereinheit 26 voreingestellt. Da sich bei diesem Zählerstand die Signale aller Zählerbits des Binärzählers 34 im Zustand H befinden, nehmen die Signale aller Zählerbits 0 bis N den Zustand L an, wenn bei gestartetem Überwachungszyklus die erste positive Taktflanke auftritt. Sowohl der Multiplexer 10 als auch der Referenzwertespeicher 30 werden dann mit einer Adresse adressiert, die an sämtlichen Adressstellen den Zustand L hat. Bei dieser Adresse wird der Analogeingang 1 des Multiplexers 10 mit dessen Ausgang 14 verbunden, so daß das erste zu überwachende Signal dem Halteglied 16 zugeführt wird. Bei Zustand H des Taktsignals CL wird der Steuereingang 48 des Haltegliedes 16 vom UND-Glied 52 durch ein Signal mit dem Zustand H beaufschlagt, so daß das am Halteglied 16 anliegende Signal in dieses übernommen und damit dem Meßeingang 18 des Komparators 20 zugeführt wird.

Gleichzeitig wird der unter der Adresse 0 im Referenzwertespeicher 30 für das erste zu überwachende Signal digital gespeicherte kleine Referenzwert ausgelesen und über den Digital/Analog-Umsetzer 24 dem Referenzeingang 22 des Komparators 20 zugeführt. Da das erste zu überwachende Signal eine Spannung von 2 V hat und somit den unter der Adresse 0 im Referenzwertespeicher 30 gespeicherten Referenzwert von 1 V überschreitet, behält das Komparatorausgangssignal seinen Zustand L bei. Dieses Komparatorausgangssignal wird mit dem Signal ZB 0 des Zählerbits 0 im EXKLUSIV-ODER-Glied 56 verknüpft. Da das Signal ZB 0 des Zählerbits 0 den Zustand L hat, nimmt das am Ausgang 58 des EXKLUSIV-ODER-Gliedes 56 erscheinende Signal in Übereinstimmung mit dem Ausgangssignal des Komparators 20 den Zustand L an.

Mit der nächsten positiven Flanke des Taktsignals CL wird der momentane Zustand des Ausgangssignals des EXKLUSIV-ODER-Gliedes 56 in das Schieberegister 62 übernommen. Gleichzeitig wird mit dieser positiven Flanke der Binärzähler 34 mit I inkrementiert, so daß das Signal des Zählerbits 0 jetzt den Zustand H hat. Da das Zählerbit 0 nicht an den Multiplexer 10 angeschlossen ist, bleibt am Ausgang 14 des Multiplexers 10 weiterhin das erste zu überwachende Signal erhalten. Das Halteglied 16 ist gesperrt, da das an dessen Steuereingang 48 anliegende Ausgangssignal des UND-Gliedes 52 bei einem Signal des Zählerbits 0 mit dem Zustand H den Zustand L annimmt. Da das Signal des Zählerbits 0 aber zur Adressierung des Referenzwertespeichers 30 verwendet wird, wird der unter der Adresse 1 für das erste zu überwachende Signal gespeicherte große Referenzwert von 3 V ausgelesen und über den Digital/Analog-Umsetzer 24 dem Referenzeingang 22 des Komparators 20 zugeführt. Da dieser Referenzwert größer als das erste zu überwachende Signal von 2 V ist, nimmt das Komparatorausgangssignal den Zustand H an. Durch Verknüpfung dieses Komparatorausgangssignals mit dem sich im Zustand H befindenden Signal des Zählerbits 0 im EXKLUSIV-ODER-Glied 56 ergibt sich an dessen Ausgang 58 ein Signal mit dem Zustand L. Dies steht im Einklang mit Fig. 2, die zeigt, daß das am Analogeingang 1 des Multiplexers 10 anliegende erste zu überwachende Signal größer als der dafür vorgesehene kleine Referenzwert von 1 V und kleiner als der große Referenzwert von 3 V ist.

Mit der nächsten positiven Flanke des Taktsignals CL wird der momentane Zustand des Ausgangssignals des EXKLUSIV-ODER-Gliedes 56 wieder in das Schieberegister 62 übernommen. Ferner wird der Binärzähler 34 erneut um 1 auf den Zählerwert 2 hochgezählt (Signal des Zählerbits 1=H und Signal des Zählerbits 0=L). Mit dieser Adresse wird der Analogeingang 2 des Multiplexers 10 mit dessen Ausgang 14 verbunden, so daß das zweite zu überwachende Signal von 1 V dem Meßeingang 18 des Komparators 20 zugeführt wird. Gleichzeitig wird der für das zweite zu überwachende Signal vorgesehene kleine Referenzwert von 2 V dem Referenzeingang 22 des Komparators 20 zugeführt. Da der kleine Referenzwert aber größer als das zweite zu überwachende Signal ist, nimmt das Signal am Ausgang 58 des EXKLUSIV-ODER-Gliedes 56 den Zustand H an, d.h. es liegt ein Fehlersignal vor.

Durch erneutes Inkrementieren des Binärzählers 34 wird der unter der Adresse 3 im Referenzwertespeicher 30 für das zweite zu überwachende Signal gespeicherte große Referenzwert von 3 V dem Komparator 20 zugeführt. Da dieser Referenzwert größer als das zweite zu überwachende Signal ist, nimmt das Ausgangssignal des EXKLUSIV-ODER-Gliedes 56 erneut den Zustand L an ; es ergibt sich also kein Fehlersignal.

Das nächste Inkrementieren des Binärzählers 34 führt dazu, daß der unter der Adresse 4 für das dritte zu überwachende Signal von 3 V im Referenzwertespeicher 30 gespeicherte kleine Referenzwert von – 1V dem Komparator 20 zugeführt wird. Ferner wird der Analogeingang 3 des Multiplexers 10 mit dessen Ausgang 14 verbunden. Da das zu überwachende Signal mit 3 V nicht unter dem kleinen Referenzwert von –1V liegt, entsteht kein Fehlersignal am Ausgang 58 des EXKLUSIV-ODER-Gliedes 56. Dies ist erst mit weiterem Inkrementieren des Binärzählers 34 möglich, wenn der unter der Adresse 5 gespeicherte große Referenzwert von 1 V dem Komparator 20 zugeführt wird. Da dann das zu überwachende Signal mit 3 V über dem großen Referenzwert von 1 V liegt, entsteht ein Fehlersignal. Auch diese Meßschritte sind der Darstellung in Fig. 2 zu entnehmen.

Durch das sukzessive Inkrementieren des Binärzählers 34 bis zum Zählerstand $2^{N+1}-1$ werden sämtliche $2^N$ elektrischen analogen Signale jeweils mit einem für sie vorgesehenen kleinen und großen Referenzwert verglichen. Sie werden also hinsichtlich der Einhaltung vorgegebener Toleranzbereiche selbsttätig überprüft.

Nach Ende eines Überwachungszyklus für mehrere Signale können vor Beginn des nächsten Überwachungszyklus die in dem gerade beendeten Überwachungszyklus aufgetretenen und im Schieberegister 62 gespeicherten Fehlersignale in einer elektronischen Datenverarbeitungsanlage ausgewertet werden.

Sollte während eines Überwachungszyklus eine Fehlmessung auftreten und in der Steuereinheit 26 bzw. der mit ihr verbundenen Datenverarbeitungsanlage als solche erkannt werden, so ist es möglich, diese Messung sofort zu wiederholen, indem die Steuereinheit 26 über den Zählrichtungseingang 40 den Binärzähler 34 entsprechend steuert Außerdem ist es möglich, während eines Überwachungszyklus eventuell nicht belegte Analogeingänge 12 des Multiplexers 10 zu überspringen, indem die Zahl der Meßstellen über den Zählvoreinstellungseingang 42 des Binärzählers 34 so voreingestellt wird, daß die Adressen der nicht belegten Analogeingänge 12 übersprungen werden.

## Ansprüche

1. Schaltungsanordnung zum selbsttätigen Überwachen mehrerer analoger elektrischer Signale (1,2, 3...) auf Einhaltung vorgegebener Toleranzbereiche durch sukzessives Vergleichen mit Referenzwerten und vergleichsabhängiges Erzeugen und Speichern von Fehlersignalen, dadurch **gekennzeichnet**, daß taktgesteuert gleichzeitig mit der Anschaltung des jeweiligen zu überwachenden Signals an einen Komparator (20) ein Zugriff auf einen Referenzwertespeicher (30) erfolgt, aus dem einem jeden Signal zugeordnete und einen Toleranzbereich definierende Referenzwerte nacheinander taktgesteuert ausgelesen und dem Komparator (20) zugeführt werden und daß das jeweilige Ausgangssignal des Komparators (20) zur Erzeugung gleichartiger zu speichernder Fehlersignale mit einem Auswertesignal (ZB 0) logisch verknüpft wird, das angibt, welcher der beiden Referenzwerte jeweils am Komparator (20) anliegt.

2. Schaltungsanordnung nach Anspruch 1, dadurch **gekennzeichnet**, daß zur sukzessiven Zuführung der analogen elektrischen Signale zum Komparator (20) ein Multiplexer (10) vorgesehen ist.

3. Schaltungsanordnung nach Anspruch 1 oder 2, dadurch **gekennzeichnet**, daß der Komparator (20) zur Ansteuerung mit den Referenzwerten über einen Digital/Analog-Umsetzer (24) mit dem die Referenzwerte digital enthaltenden Referenzwertespeicher (30) verbunden ist.

4. Schaltungsanordnung nach Anspruch 3, dadurch **gekennzeichnet**, daß der Referenzwertespeicher (30) frei programmierbar ist.

5. Schaltungsanordnung nach Anspruch 3 oder 4, dadurch **gekennzeichnet**, daß der Referenzwertespeicher (30) für jedes zu überwachende Signal unter einer geradzahligen Adresse den kleinen oder den großen Referenzwert und unter der nächsthöheren, ungeradzahligen Adresse den großen bzw. den kleinen Referenzwert enthält und daß der Referenzwertespeicher (30) mit gegenüber dem Multiplexer (10) doppelter Frequenz bei sukzessiv ansteigender Adressenfolge adressiert wird.

6. Schaltungsanordnung nach Anspruch 5 zur Überwachung von maximal $2^N$ analogen elektrischen Signalen, dadurch **gekennzeichnet**, daß der Referenzwertespeicher (30) mit den Signalen der Zählerbits 0 bis N und der Multiplexer (10) mit den Signalen der Zählerbits 1 bis N eines Binärzählers (34) adressiert wird.

7. Schaltungsanordnung nach Anspruch 6, dadurch **gekennzeichnet**, daß das Auswertesignal (ZB 0) durch das Signal des Zählerbits 0 des Binärzählers (34) gebildet wird.

8. Schaltungsanordnung nach Anspruch 7, dadurch **gekennzeichnet**, daß die logische Verknüpfung des jeweiligen Ausgangssignals des Komparators(20) mit dem Signal des Zählerbits 0 des Binärzählers (34) durch ein EXKLUSIV-ODER-Glied (56) erfolgt.

9. Schaltungsanordnung nach einem der Ansprüche 6 bis 8, dadurch **gekennzeichnet**, daß der Multiplexer (10) und der Komparator (20) über ein hinsichtlich der Übernahme des jeweiligen Multiplexerausgangssignals steuerbares Halteglied (16) miteinander verbunden sind, dessen Steuereingang (48) an den Ausgang (50) eines UND-Gliedes (52) angeschlossen ist, das das invertierte Signal des Zählerbits 0 des Binärzählers (34) mit einem diesen inkrementierenden Taktsignal (CL) verknüpft.

10. Schaltungsanordnung nach einem der vorhergehenden Ansprüche, dadurch **gekennzeichnet**, daß die in einem Überwachungszyklus auftretenden Fehlersignale jeweils bis zum Beginn des nächsten Überwachungszyklus in einem Schieberegister (62) gespeichert werden.

11. Schaltungsanordnung nach Anspruch 10, dadurch **gekennzeichnet**, daß eine Steuereinheit (26) vorgesehen ist, die die Programmierung des Referenzwertespeichers (30) zwischen zwei Überwachungszyklen, das definierte Starten und Stoppen der Überwachungszyklen und das Auswerten der im Schieberegister (62) gespeicherten Fehlersignale durch eine elektronische Datenverarbeitungsanlage steuert.

## Claims

1. Circuit arrangement for automatically monitoring several analog electric signals (1,2,3...) with respect to maintaining predetermined tolerance ranges by successive comparison with reference values and generating and storing error signals dependent on said comparison, **characterized** in that clock-controlled and simultaneous with the connection of the respective signal to be monitored to a comparator (20), an access to a reference value store (30) is carried out, from which reference values assigned to each signal and defining a tolerance range are successively read out under clock control and fed to the comparator (20), and that the respective output signal of the comparator (20) is logically combined with an evaluating signal (ZB 0) for the generation of similar error signals to be stored, said evaluating signal indicating which of the two reference values, respectively, is fed to the comparator (20).

2. Circuit arrangement according to claim 1, **characterized** in that a multiplexer (10) is provided for successive feed of the analog electric signals to the comparator (20).

3. Circuit arrangement according to claim 1 or 2, **characterized** in that the comparator (20), for feeding with the reference values is connected via a digital/analog converter (24) with the reference value store (30) containing the reference values in digital form.

4. Circuit arrangement according to claim 3, **characterized** in that the reference value store (30) is freely programmable.

5. Circuit arrangement according to claim 3 or 4,

characterized in that the reference value store (30), for each signal to be monitored, contains under an even numbered address the small or the large reference value and under the next higher, odd numbered address the large or the small reference value, and that the reference value store (30) is addressed at double frequency relative to the multiplexer (10) with successively increasing address sequence.

6. Circuit arrangement according to claim 5 for monitoring of a maximum of $2^N$ analog electric signals, characterized in that the reference value store (30) is addressed by the signals of the counter bits 0 to N and the multiplexer (10) by the signals of the counter bits 1 to N of a binary counter (34).

7. Circuit arrangement according to claim 6, characterized in that the evaluating signal (ZB 0) is formed by the signal of the counter bit 0 of the binary counter (34).

8. Circuit arrangement according to claim 7, characterized in that the logic combination of the respective output signal of the comparator (20) with the signal of the counter bit 0 of the binary counter (34) is effected by an EXCLUSIVE-OR gate (56).

9. Circuit arrangement according to any one of the claims 6 to 8, characterized in that the multiplexer (10) and the comparator (20) are interconnected via a hold member (16) controllable with respect to the taking over of the respective multiplexer output signal, the control input (48) of which is connected to the output (50) of an AND gate (52) which combines the inverted signal of the counter bit 0 of the binary counter (34) with a clock signal (CL) incrementing the binary counter (34).

10. Circuit arrangement according to any one of the foregoing claims, characterized in that the error signals occurring in one monitoring cycle are respectively stored in a shift register (62) up to the start of the next monitoring cycle.

11. Circuit arrangement according to claim 10, characterized in that a control unit (26) is provided for controlling the programming of the reference value store (30) between two monitoring cycles, the defined starting and stopping of the monitoring cycles and the evaluation of the error signals stored in the shift register (62) by an electronic data processing device.

## Revendications

1. Dispositif pour la surveillance automatique de plusieurs signaux (1,2,3..) électriques analogiques dans le respect de bandes de tolérance prédéterminées, par des comparaisons successives à des valeurs de référence, et par la production en fonction de la comparaison et la mise en mémoire de signaux d'erreur, caractérisé en ce que, par commande cadencée, simultanément à l'introduction dans un comparateur (20), du signal respectif à surveiller, il s'établit un accès à une mémoire (30) de valeurs de référence, dans laquelle des valeurs de référence associées à chaque signal et définissant une bande de tolérances sont lues l'une après l'autre par commande cadencée, et sont conduites au comparateur (20) et en ce que le signal de sortie correspondant du comparateur (20) est relié logiquement, pour la production des signaux d'erreur similaires à mémoriser, à un signal d'évaluation (ZB 0) qui indique laquelle des deux valeurs de référence respective est appliquée au comparateur (20).

2. Dispositif selon la revendication 1 caractérisé en ce qu'il est prévu un multiplexeur (10) pour conduire successivement les signaux électriques analogiques au comparateur (20).

3. Dispositif selon la revendication 1 ou 2, caractérisé en ce que, pour l'alimentation en valeurs de référence, le comparateur (20) est relié par l'intermédiaire d'un convertisseur numérique/analogique (24) à la mémoire (30) de valeurs de référence contenant les valeurs de référence sous forme numérique.

4. Dispositif selon la revendication 3 caractérisé en ce que la mémoire (30) de valeurs de référence est librement programmable.

5. Dispositif selon la revendication 3 ou 4, caractérisé en ce que la mémoire (30) de valeurs de référence contient, pour chaque signal à surveiller, sous une adresse paire la petite ou la grande valeur de référence et sous l'adresse impaire immédiatement supérieure respectivement la grande ou la petite valeur de référence, et en ce que la mémoire (30) de valeurs de référence est adressée à une fréquence double par rapport à celle du multiplexeur (10) par une séquence d'adresses successivement croissantes.

6. Dispositif selon la revendication 5 pour la surveillance au maximum de $2^N$ signaux électriques analogiques, caractérisé en ce que la mémoire (30) de valeurs de référence est adressée avec les signaux des chiffres binaires de comptage de 0 à N et en ce que le multiplexeur (10) est adressé avec les signaux des chiffres binaires de comptage 1 à N d'un compteur binaire (34).

7. Dispositif selon la revendication 6 caractérisé en ce que le signal d'évaluation (ZB 0) est constitué par le signal du chiffre binaire de comptage 0 du compteur binaire (34).

8. Dispositif selon la revendication 7 caractérisé en ce que la liaison logique du signal correspondant de sortie du comparateur (20) avec le signal du chiffre binaire de comptage 0 du compteur binaire (34) est réalisée par une porte OU-EXCLUSIF (56).

9. Dispositif selon l'une des revendications 6 à 8, caractérisé en ce que le multiplexeur (10) et le comparateur (20) sont liés l'un à l'autre par un élément de maintien (16) commandable en ce qui concerne la réception du signal correspondant de sortie du multiplexeur, l'entrée de commande (48) de cet élément de maintien étant reliée à la sortie (50) d'une porte ET (52) qui fait correspondre le signal inversé du chiffre binaire de comptage 0 du compteur binaire (34) à un signal de cycle (CL) qui incrémente celui-ci.

10. Dispositif selon l'une des revendications précédentes caractérisé en ce que les signaux d'erreur survenant pendant un cycle de surveillance sont mémorisés respectivement dans un registre à décalage (62) jusqu'au début du cycle de surveillance suivant.

11. Dispositif selon la revendication 10 caractérisé en ce qu'il est prévu une unité de commande (26) qui commande la programmation de la mémoire (30) de valeurs de référence entre deux cycles de surveillance, le début et l'arrêt définis des cycles de surveillance et l'évaluation des signaux d'erreur mémorisés dans le registre de décalage (62) par l'intermédiaire d'une unité électronique de traitement de données.

Fig. 1

Fig. 2

ANALOGEINGANG 1 — 2 V

ANALOGEINGANG 2 — 1 V

ANALOGEINGANG 3 — 3 V

MULTIPLEXER – AUSGANG 14

HALTEGLIED – AUSGANG 17

D / A – UMSETZER – AUSGANG 25

TAKTSIGNAL CL

ZÄHLERBIT 0

ZÄHLERBIT 1

ZÄHLERBIT 2

KOMPARATORAUSGANG 54

FEHLERSIGNAL 58

EP 0 224 707 B1